# EUROPÄISCHE PATENTSCHRIFT

(11) **EP 3 599 802 B1**
(45) Veröffentlichungstag und Bekanntmachung des Hinweises auf die Patenterteilung: **05.01.2022**
(21) Anmeldenummer: 19187263.9
(22) Anmeldetag: 19.07.2019
(51) Int. Cl.: H05K 5/00

(54) **ELEKTRONISCHE VORRICHTUNG MIT EINEM IN EINEN SCHUTZMANTEL EINGEBETTETES BAUTEIL**
ELECTRONIC DEVICE COMPRISING A COMPONENT EMBEDDED IN A PROTECTIVE SLEEVE
DISPOSITIF ÉLECTRONIQUE DOTÉ D'UN COMPOSANT INCORPORÉ DANS UNE ENVELOPPE DE PROTECTION

(30) Priorität: 24.07.2018 DE 102018212327
(43) Veröffentlichungstag der Anmeldung: 29.01.2020
(73) Patentinhaber: Robert Bosch GmbH, 70442 Stuttgart (DE)
(72) Erfinder: Burkhardt, Holger, 72762 Reutlingen (DE); Remus, Joerg, 72768 Reutlingen (DE); Dillmann, Stephan, 72762 Reutlingen (DE); Maenz, Torsten, 97078 Wuerzburg (DE)

(56) Entgegenhaltungen:
- DE-A1-102008 043 774
- DE-A1-102010 002 945
- DE-A1-102016 204 811

## Beschreibung

### Stand der Technik

Die Erfindung betrifft eine elektronische Vorrichtung, insbesondere ein Steuergerät für ein Kraftfahrzeug. Die Vorrichtung weist elektrische Komponenten, umfassend wenigstens einen Schaltungsträger, und einen mit dem Schaltungsträger verbundenes druckempfindliches elektronisches Bauteil, insbesondere einen Elektrolytkondensator oder einen Schwingquarz auf. Wenigstens ein Teil der Komponenten sind jeweils wenigstens teilweise in eine Mold-Masse eingebettet, wie zum Beispiel in Dokumenten DE 10 2008 043774, DE 10 2016 204811 und DE 10 2010 002945.

### Offenbarung der Erfindung

Erfindungsgemäß weist die Vorrichtung nach Anspruch 1 einen Behälter mit einer Behälteröffnung auf, wobei der Elektrolytkondensator in dem Behälter aufgenommen ist. Der Behälter ist mit einer insbesondere niedrigviskosen Vergussmasse gefüllt, sodass der Elektrolytkondensator von der Vergussmasse umschlossen, bevorzugt in die Vergussmasse eingebettet, ist. Die Mold-Masse schließt an den Behälter, insbesondere an eine Behälteraußenwand des Behälters, und/oder die Vergussmasse im Bereich der Behälteröffnung materialschlüssig und/oder stoffschlüssig an.

Ausserdem bildet die Vergussmasse so einen Schutzmantel für den Elektrolytkondensator. Der Schutzmantel ist bevorzugt in dem Behälter erzeugt, wobei der Behälter Bestandteil der Vorrichtung ist. Vorteilhaft kann der Elektrolytkondensator durch den so gebildeten Schutzmantel von der Mold-Masse, welche beispielsweise unter Hochdruck, insbesondere bei wenigstens 50 Bar, bevorzugt zwischen 50 und 150 bar, in eine Werkzeugform eingeschossen wird, beim Umhüllen der übrigen elektronischen Komponenten nicht beschädigt oder zerstört werden. Es wurde nämlich erkannt, dass der Elektrolytkondensator beim Ummolden mittels Transfermolden, Spritzgießen oder mittels Compression Molding beschädigt, insbesondere eingedrückt werden kann.

In einer bevorzugten Ausführungsform ist der Behälter wenigstens teilweise durch ein Kunststoffteil gebildet, welches den Kondensator umschließt. Das Kunststoffteil ist beispielsweise ein Rohrabschnitt. Der Rohrabschnitt kann vorteilhaft auf den Schaltungsträger gestellt werden. Der Rohrabschnitt ist bevorzugt ausgebildet, gegen den Schaltungsträger abzudichten. Vorteilhaft kann der Behälter so mit der niedrigviskosen Vergussmasse, insbesondere Epoxidharz, gefüllt werden, sodass der Kondensator, welcher in dem Behälter aufgenommen ist, von der niedrigviskosen Vergussmasse umhüllt, und so eingebettet sein kann.

In einer anderen Ausführungsform ist ein Endabschnitt des Schaltungsträgers, mit dem der Elektrolytkondensator verbunden ist, gemeinsam mit dem Elektrolytkondensator in dem Behälter angeordnet. Der Endabschnitt kann beispielsweise zusammen mit dem Elektrolytkondensator in den Behälter eingeführt werden. Anschließend kann der Behälter mit der niedrigviskosen Vergussmasse gefüllt werden, wobei der Endabschnitt des Schaltungsträgers und der Elektrolytkondensator dabei mit Vergussmasse bedeckt werden. Vorteilhaft ist der Elektrolytkondensator so vollständig in die Vergussmasse eingebettet, sodass bei einem anschließenden Ummolden mit einer Mold-Masse unter Hochdruck der Elektrolytkondensator nicht beschädigt werden kann, insoweit die dann ausgehärtete niedrigviskose Vergussmasse einen Schutzmantel für den Elektrolytkondensator bildet.

In einer bevorzugten Ausführungsform ist eine Behälterwand des Behälters durch den Schaltungsträger gebildet, und das Kunststoffteil ist gegen den Schaltungsträger abgedichtet. Vorteilhaft kann der Behälter so aufwandsgünstig bereitgestellt werden.

In einer bevorzugten Ausführungsform weist die Vorrichtung einen Steckanschluss auf, wobei der Steckanschluss durch ein an den Behälter angeformtes Teil, insbesondere Kunststoffteil gebildet ist. Vorteilhaft kann die elektronische Vorrichtung so aufwandsgünstig bereitgestellt werden.

In einer bevorzugten Ausführungsform weist der Steckanschluss eine Steckerwand auf, durch die mit dem Schaltungsträger verbundene elektrische Kontakte hindurchgeführt sind. Die Steckerwand bildet bevorzugt eine Behälterwand des Behälters. Vorteilhaft können so die Durchführungen der Kontakte durch die niedrigviskose Vergussmasse, die - insbesondere an einer Innenseite des Steckanschlusses - herausragen und zu dem Schaltungsträger hingeführt sind, im Bereich des Durchtritts durch die Steckerwand mittels der Vergussmasse gegen die Steckerwand fixiert und zusätzlich abgedichtet sein.

Zum Erzeugen der Vorrichtung können die Steckkontakte beispielsweise mit dem Schaltungsträger mittels Löten oder mittels einer Einpressverbindung verbunden sein. Die Steckanschlüsse können beispielsweise abgewinkelt von dem Schaltungsträger wegragen. Der Steckanschluss, insbesondere das den Steckanschluss bildende Kunststoffteil, kann dann in einem weiteren Schritt auf die Steckkontakte aufgeschoben werden. Eine an den Steckanschluss angeformte Behälterwand kann dabei den Endabschnitt des Schaltungsträgers, auf dem der Elektrolytkondensator angeordnet ist, umschließen oder aufnehmen. Der so gebildete Behälter, welcher durch einen Teil des Steckanschlusses gebildet ist, kann dann mit der niedrigviskosen Vergussmasse gefüllt werden.

Bevorzugt sind die Durchbrüche in der Steckerwand jeweils konisch ausgebildet, sodass ein Einführen der Steckkontakte beim Aufschieben des Steckanschlusses erleichtert werden kann.

Die Steckkontakte können in einer anderen Ausführungsform von dem Steckanschluss, insbesondere dem den Steckanschluss bildenden Kunststoffteil umspritzt sein. Die Steckkontakte können so - beispielsweise abgewinkelt - mittels THT-Technologie (THT = Through-Hole-Technology) mit dem Schaltungsträger verbunden und verlötet werden.

In einer bevorzugten Ausführungsform ist die Vergussmasse durch ein Harz, insbesondere Epoxidharz, gebildet. Die Vergussmasse kann so aufwandsgünstig als niedrigviskose Vergussmasse bereitgestellt werden. Die Vergussmasse ist beispielsweise partikelgefüllt, insbesondere mit Keramikpartikeln gefüllt. Die Vergussmasse kann so vorteilhaft von dem Elektrolytkondensator erzeugte Verlustwärme gut an den Steckanschluss ableiten.

In einer bevorzugten Ausführungsform ist die Mold-Masse durch eine insbesondere partikelgefüllte Spritzgussmasse gebildet. Die Partikel sind beispielsweise Keramikpartikel.

Bevorzugt beträgt ein Füllgrad, insbesondere ein Volumen- oder Gewichtsanteil der Füllpartikel in der niedrigviskosen Vergussmasse, weniger als der Füllpartikelanteil in der Mold-Masse, bevorzugt weniger als die Hälfte, weiter bevorzugt weniger als ein Viertel des Füllpartikelanteils in der Mold-Masse. Die Partikel sind bevorzugt Keramikpartikel, insbesondere Aluminiumoxidpartikel, Nitridpartikel, insbesondere Bornitridpartikel, oder Karbidpartikel, insbesondere Siliziumkarbidpartikel oder Siliziumoxidpartikel.

Die Mold-Masse ist bevorzugt durch einen Duroplast, insbesondere Phenolharz, Melaminharz, Methanalharz oder eine insbesondere partikelgefüllte BMC-Masse (BMC = Bulk-Molding-Compound) gebildet. Die BMC-Masse weist bevorzugt Polyester- und/oder Vinylesterharz auf.

Bevorzugt ist die Moldmasse durch ein Reaktionsharz, insbesondere Polykarbonat oder ein partikelgefülltes Epoxidharz, gebildet. In einer bevorzugten Ausführungsform ist die Vergussmasse von der Mold-Masse verschieden. Beispielsweise ist die Vergussmasse durch ein Epoxidharz gebildet und die Mold-Masse durch ein Phenolharz gebildet. Die Erfindung betrifft auch ein Verfahren nach Anspruch 10 zum Erzeugen einer elektronischen Vorrichtung, insbesondere der Vorrichtung der vorbeschriebenen Art. Bei dem Verfahren wird ein druckempfindliches elektronisches Bauteil, wie zum Beispiel ein Elektrolytkondensator oder ein Schwingquarz, mit einem Schaltungsträger elektrisch und mechanisch verbunden. Das Bauteil wird in einem weiteren Schritt mit einem Behälter umschlossen, sodass das Bauteil in dem Behälter aufgenommen ist. In einem folgenden Schritt wird der Behälter mit einer insbesondere niedrigviskosen Vergussmasse - insbesondere überdrucklos - bevorzugt im Vakuum und/oder mittels bloßer Schwerkraft beispielsweise durch Eingießen - gefüllt, sodass das Bauteil von der Vergussmasse umschlossen, bevorzugt in die Vergussmasse eingebettet, ist. In einem weiteren Schritt wird das Bauteil mit einer Spritzgussmasse ummoldet, wobei die Spritzgussmasse an die Vergussmasse und/oder den Behälter anschließt. Die Vergussmasse und die Mold-Masse können so vorteilhaft einander kontaktieren. Bevorzugt ist zwischen der Mold-Masse und der Vergussmasse eine stoffschlüssige oder materialschlüssige Grenzschicht gebildet.

Das Einfüllen der niedrigviskosen Vergussmasse erfolgt bevorzugt im Vakuum. Vorteilhaft können so Lunker in der Vergussmasse vermieden werden. Weiter bevorzugt erfolgt das Einfüllen derart, dass auf den Kondensator gegenüber einem normalen Umgebungsluftdruck kein erhöhter Druck wirkt oder dass eine Beschädigung des Kondensators ausgeschlossen ist. Ein Umgebungsluftdruck beträgt beispielsweise 1013 Hektopascal.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.
Figur 1 zeigt - schematisch - ein Ausführungsbeispiel für eine elektronische Vorrichtung, bei der ein druckempfindliches Bauelement, insbesondere ein Elektrolytkondensator mit einem Schaltungsträger lötverbunden ist;
Figur 2 zeigt die in Figur 1 dargestellte elektronische Vorrichtung bei der der Elektrolytkondensator in eine insbesondere niedrigviskose Vergussmasse eingeschlossen wird;
Figur 3 zeigt die in Figur 2 dargestellte elektronische Vorrichtung bei der der Schaltungsträger und die übrigen elektronischen Komponenten mit einer Moldmasse umhüllt werden, wobei die Moldmasse an die Vergussmasse unter Ausbildung einer Grenzschicht zwischen den Massen anschließt;
Figur 4 zeigt - schematisch - eine elektronische Vorrichtung, bei der auf zueinander gegenüberliegenden Seiten des Schaltungsträgers jeweils ein Elektrolytkondensator angeordnet und mit dem Schaltungsträger verbunden ist;
Figur 5 zeigt - schematisch - ein Ausführungsbeispiel für eine elektronische Vorrichtung, bei der ein Elektrolytkondensator mit einem Rohrabschnitt von einer Moldmasse isoliert ist, wobei der in dem Rohrabschnitt verbleibende Hohlraum mit einer Vergussmasse gefüllt ist.

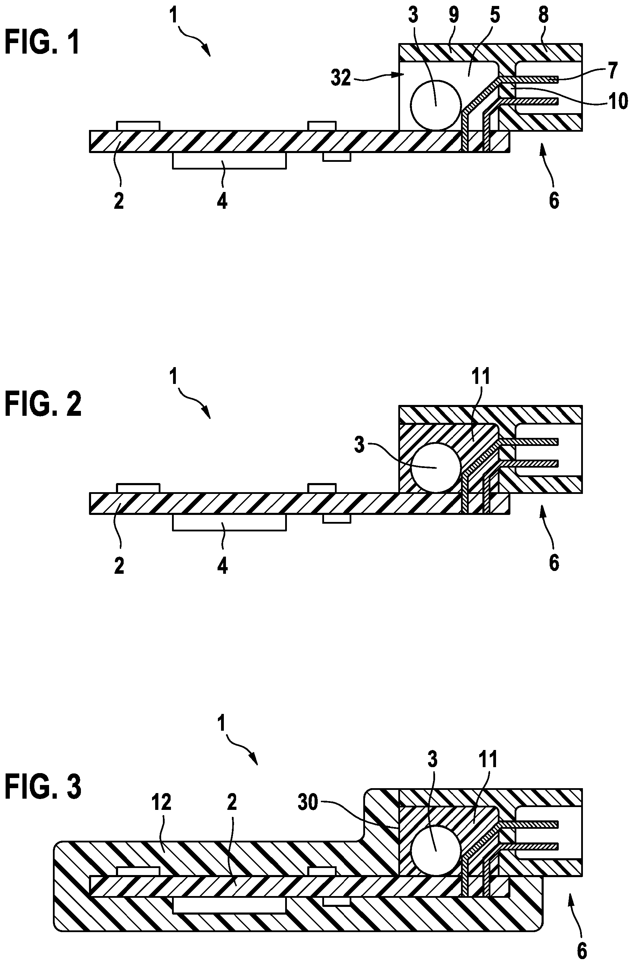

Figur 1 zeigt ein Ausführungsbeispiel für eine elektronische Vorrichtung 1, welche in Figur 1 teilweise dargestellt ist. Die elektronische Vorrichtung 1 weist einen Schaltungsträger 2 auf. Mit dem Schaltungsträger 2 ist in diesem Ausführungsbeispiel ein Elektrolytkondensator 3 elektrisch und mechanisch verbunden. Der Schaltungsträger 2 weist noch weitere elektronische Komponenten auf, von denen ein integrierter Schaltkreis 4 beispielhaft bezeichnet ist. Die elektronische Vorrichtung 1 bildet in diesem Ausführungsbeispiel ein Steuergerät, insbesondere ein Steuergerät für ein Kraftfahrzeug.

Die elektronische Vorrichtung 1 weist in diesem Ausführungsbeispiel einen Steckanschluss 6 zum elektrischen Verbinden der elektronischen Vorrichtung 1 mit einer weiteren elektrischen Komponente, beispielsweise mit einem Gegenstecker, auf. Der Steckanschluss 6 umfasst in diesem Ausführungsbeispiel elektrische Kontakte, von denen ein elektrischer Kontakt 7 beispielhaft bezeichnet ist.

Der Steckanschluss 6 weist in diesem Ausführungsbeispiel einen Steckkragen 8 auf, welcher die elektrischen Kontakte, und so auch den elektrischen Kontakt 7, umschließt. Der Steckanschluss 6 weist in diesem Ausführungsbeispiel eine an den Steckanschluss 6 angeformte Becherwand 9 auf, welche sich in diesem Ausführungsbeispiel parallel zur flachen Erstreckung des Schaltungsträgers 2 erstreckt. Der Steckanschluss 6 weist eine Steckerwand 10 auf, durch die der wenigstens eine elektrische Kontakt 7 hindurchgeführt ist. Der elektrische Kontakt 7 ist mit dem Schaltungsträger 2 elektrisch verbunden, insbesondere Lötverbunden.

Der Steckanschluss 6, insbesondere die Steckerwand 10, und die an die Steckerwand 10 angeformte Behälterwand 9 umschließen gemeinsam mit einem Endabschnitt des Schaltungsträgers 2 einen Hohlraum 5, in dem der Elektrolytkondensator 3 aufgenommen ist. Der Steckanschluss 6 dichtet in diesem Ausführungsbeispiel gegen den Endabschnitt des Schaltungsträgers 2 hinreichend ab, sodass - wie in Figur 2 dargestellt - der Hohlraum 5, - insbesondere der zwischen dem Elektrolytkondensator 3 und den Behälterwänden des Behälters verbleibende Hohlraum -, mit einer niedrigviskosen Vergussmasse 11 durch eine Öffnung 32 gefüllt werden kann.

In Figur 2 sind die in Figur 1 bereits gezeigten Teile der elektronischen Vorrichtung 1 dargestellt, wobei der Hohlraum 5 mit der Vergussmasse 11 angefüllt ist, sodass der Kondensator 3 von der Vergussmasse 11 umschlossen, und so - insbesondere vollständig - in die Vergussmasse 11 eingebettet ist.

Der elektrische Kontakt 7 ist auf einem Längsabschnitt, welcher sich zwischen der Steckerwand 10 und dem Schaltungsträger 2 erstreckt, ebenfalls in die Vergussmasse 11 eingebettet.

Figur 3 zeigt einen weiteren Schritt zum Erzeugen der elektronischen Vorrichtung 1, bei dem die elektronische Vorrichtung 1, insbesondere die elektrischen Komponenten, umfassend den Schaltungsträger 2 und die mit dem Schaltungsträger 2 verbundenen elektronischen Bauteile, beispielsweise der integrierte Schaltkreis 4, von einer Spritzgussmasse 12 umgeben, und so in die Spritzgussmasse 12 eingebettet wird. Die Spritzgussmasse 12 schließt dabei an die Vergussmasse 11 an, sodass zwischen der Vergussmasse 11 und der Mold-Masse 12 eine Grenzschicht 30 gebildet ist. Die Mold-Masse 12 ist in diesem Beispiel mittels eines Transfer-Mold-Verfahrens unter Überdruck, beispielsweise mit mindestens 50 Bar, erzeugt. Dazu wird die elektronische Vorrichtung, umfassend den Schaltungsträger 2 und den Steckanschluss 6, in zwei Werkzeughälften eingeschlossen, welche nach dem Verschließen mit der Mold-Masse unter hohem Einfülldruck gefüllt werden können. Nach dem Öffnen der Werkzeughälften ist der Schaltungsträger 2 und die mit dem Schaltungsträger 2 verbundenen elektronischen Komponenten von der Mold-Masse umschlossen.

Die Mold-Masse schließt in diesem Ausführungsbeispiel an den Steckanschluss 6 an und bedeckt so einen Teil des Steckanschlusses 6. Die Vergussmasse 11 bildet beim Einmolden des Schaltungsträgers 2 einen für den Elektrolytkondensator 3, der hinreichend druckfest ausgebildet ist, sodass der Elektrolytkondensator 3 durch den Druck, insbesondere Überdruck beim Ummolden des Schaltungsträgers 2 keinen Schaden nehmen kann.

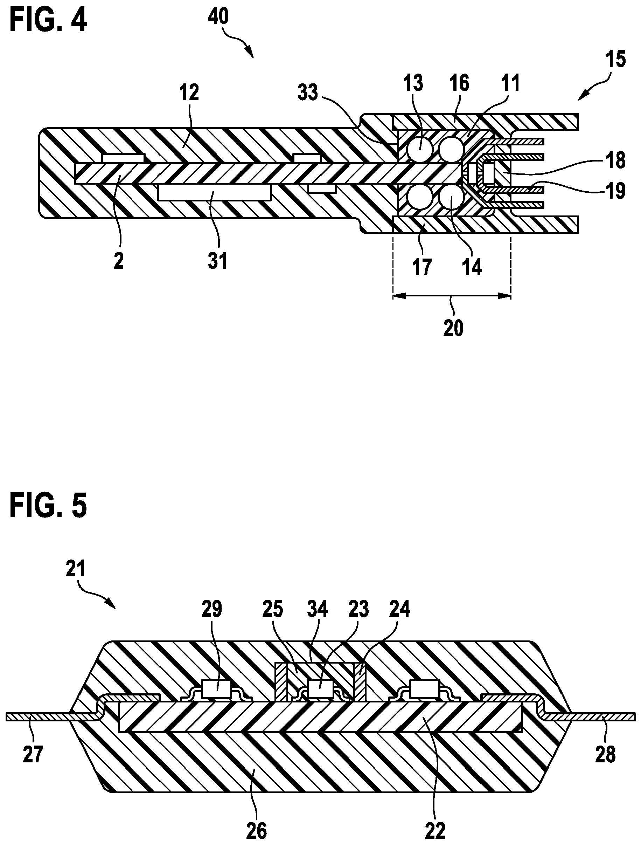

Figur 4 zeigt ein Ausführungsbeispiel für eine elektronische Vorrichtung 40 in einer Schnittdarstellung. Die elektronische Vorrichtung 40 bildet in diesem Ausführungsbeispiel eine Variante der in den Figuren 1, 2 und 3 gezeigten elektronischen Vorrichtung 1. Die elektronische Vorrichtung 40 weist einen Schaltungsträger 2 auf, mit dem elektronische Komponenten verbunden sind, von denen ein integrierter Schaltkreis 31 beispielhaft bezeichnet ist. Die Vorrichtung 40 umfasst in diesem Ausführungsbeispiel einen Steckanschluss 15. Der Steckanschluss 15 ist in diesem Ausführungsbeispiel einstückig als Kunststoffteil ausgebildet. Der Steckanschluss 15 umfasst eine Steckerwand 18, durch die elektrischen Kontakte hindurchgeführt sind, und mit einem Endabschnitt aus der Steckerwand 18 herausragen. Von den elektrischen Kontakten ist ein Kontakt 19 beispielhaft bezeichnet. Die elektrischen Kontakte sind jeweils mit dem Schaltungsträger 2 - beispielsweise mittels Verlöten oder mittels einer Schneid-Klemm-Verbindung oder mittels einer THT-Einpresstechnik (THT = Through-Hole-Technology) - mit dem Schaltungsträger 2 - insbesondere einem Endabschnitt 20 des Schaltungsträgers 2 - elektrisch verbunden. Der Endabschnitt 20 des Schaltungsträgers ist in einem an den Steckanschluss 15 angeformten Becher, umfassend eine Becherwand 16 und eine Becherwand 17, welche sich jeweils parallel zueinander erstrecken, aufgenommen. Die Becherwände 16 und 17 sind jeweils an die Steckerwand 18 angeformt, wobei die Steckerwand 18 einen Becherboden bildet, an dem die Becherwände 16 und 17 angeformt sind. Die Becherwände 16 und 17 bilden gemeinsam mit dem durch die Steckerwand 18 gebildeten Becherboden eine U-Form. An dem Becherboden 18 ist in diesem Ausführungsbeispiel ein Steckkragen angeformt, welcher die elektrischen Kontakte, und so auch den elektrischen Kontakt 19, umschließt.

Die elektronische Vorrichtung 40 weist auch wenigstens einen Elektrolytkondensator, in diesem Ausführungsbeispiel einen Elektrolytkondensator 13, und einen Elektrolytkondensator 14 auf, welche jeweils an zueinander gegenüberliegenden Seiten des Schaltungsträgers 2 auf dem Endabschnitt 20 mit dem Schaltungsträger 2 verbunden sind. Die Elektrolytkondensatoren 13 und 14 sind so gemeinsam mit dem Endabschnitt 20 des Schaltungsträgers 2 in dem an den Steckanschluss 15 angeformten Becher, gebildet durch die Becherwände 16 und 17, und durch die Steckerwand 18 aufgenommen. Der zwischen dem Endabschnitt 20 des Schaltungsträgers und den Elektrolytkondensatoren und den Becherwänden verbleibende Hohlraum ist in diesem Ausführungsbeispiel mit niedrigviskoser Vergussmasse 11 ausgefüllt. Der übrige Teil des Schaltungsträgers, welcher so aus dem Steckanschluss 15, insbesondere aus dem an dem Steckanschluss 15 angeformten Becher, herausragt, ist mit Mold-Masse 12 ummoldet. Zwischen der Mold-Masse 12 und der Vergussmasse 11 ist eine Grenzschicht 33 ausgebildet. Die Elektrolytkondensatoren 13 und 14 sind so beim Ummolden durch den durch die ausgehärtete Vergussmasse 11 gebildeten Schutzmantel geschützt und können so durch den Druck beim Einschießen und Aushärten der Mold-Masse 12 in eine Werkzeugform nicht beschädigt werden.

Figur 5 zeigt ein Ausführungsbeispiel für eine elektronische Vorrichtung 21. Die elektronische Vorrichtung 21 umfasst einen Schaltungsträger 22, mit dem elektronische Komponenten verbunden sind, von denen ein integrierter Schaltkreis 29 beispielhaft bezeichnet ist. Mit dem Schaltungsträger 22 ist auch ein Elektrolytkondensator 23 elektrisch und mechanisch verbunden, welcher in diesem Ausführungsbeispiel ein druckempfindliches Bauteil bildet.

Der Elektrolytkondensator 23 ist in diesem Ausführungsbeispiel in einem von einem Rohrabschnitt 24 umschlossenen Hohlraum eingeschlossen. Der Rohrabschnitt 24 ist dazu über den Elektrolytkondensator 23 gestülpt worden und so auf den Schaltungsträger 22 gestellt. Der Rohrabschnitt 24 kann so in einem folgenden Schritt mit niedrigviskoser Vergussmasse 25 gefüllt werden. Der Schaltungsträger 22 bildet dabei einen Becherboden, der Rohrabschnitt 24 bildet eine Becherwand. In einem folgenden Schritt kann der Schaltungsträger 22, mit dem in diesem Ausführungsbeispiel elektrische Anschlüsse 27 und 28 verbunden sind, in einer zweiteiligen Werkzeugform mit einer Mold-Masse 26 umhüllt werden, und so in die Mold-Masse 26 eingebettet werden. Die elektrischen Anschlüsse 27 und 28 ragen beim Ummolden jeweils mit einem Endabschnitt - insbesondere an einer Grenzfläche zwischen den zwei Werkzeughälften - aus einem nach Aushärten der Mold-Masse 26 gebildeten Mold-Körper heraus.

Die Vergussmasse 25 ist in diesem Ausführungsbeispiel von der Mold-Masse 26 bedeckt, sodass zwischen der Vergussmasse 25 und der Mold-Masse 26 eine Grenzschicht 34 gebildet ist.

## Patentansprüche

1. Elektronische Vorrichtung (1), insbesondere Steuergerät für ein Kraftfahrzeug, wobei die Vorrichtung (1) elektronische Komponenten (3, 4, 29, 31, 13, 14) umfassend wenigstens einen Schaltungsträger (2, 22) und einen mit dem Schaltungsträger (2, 22) verbundenen Elektrolytkondensator (3, 13, 14, 23) aufweist, wobei wenigstens ein Teil der Komponenten jeweils wenigstens teilweise in eine Moldmasse (12, 26) eingebettet sind,
**dadurch gekennzeichnet, dass**
die Vorrichtung (1) einen Behälter (2, 6, 15, 24) mit einer Behälteröffnung (32) aufweist und der Elektrolytkondensator (3, 13, 14, 23) in dem Behälter (2, 6, 15, 24) aufgenommen ist, wobei der Behälter (2, 6, 15, 24) mit einer insbesondere niedrigviskosen Vergussmasse (11, 25) gefüllt ist, so dass der Elektrolytkondensator (3, 13, 14, 23) von der Vergussmasse (11, 25) umschlossen ist und ein Schutzmantel für den Elektrolytkondensator (3, 13, 14, 23) beim Einbetten der Komponenten in der Moldmasse (12, 26) ausgebildet ist, wobei die Moldmasse (12, 26) an den Behälter (2, 6, 15, 24) und/oder die Vergussmasse (11, 25) im Bereich der Behälteröffnung (32) materialschlüssig und/oder stoffschlüssig anschließt.

2. Vorrichtung (1) nach Anspruch 1,
**dadurch gekennzeichnet, dass**
der Behälter (2, 6, 15, 24) wenigstens teilweise durch ein Kunststoffteil (9, 10, 16, 17, 18, 24) gebildet ist, welches den Elektrolytkondensator (3, 13, 14, 23) umschließt.

3. Vorrichtung (1) nach Anspruch 1 oder 2,
**dadurch gekennzeichnet, dass**
eine Behälterwand durch den Schaltungsträger (2) gebildet ist und das Kunststoffteil (6, 10) an den Schaltungsträger (2) abgedichtet ist.

4. Vorrichtung (1) nach Anspruch 3,
**dadurch gekennzeichnet, dass**
die Vorrichtung (1) einen Steckanschluss (6, 10, 15, 19) aufweist, und der Steckanschluss (6, 15, 19) durch ein an den Behälter angeformtes Kunststoffteil (8, 10, 15, 18) gebildet ist.

5. Vorrichtung (1) nach Anspruch 4,
**dadurch gekennzeichnet, dass**
der Steckanschluss (6, 15, 19) eine Steckerwand (10, 18) aufweist, durch die mit dem Schaltungsträger (2) verbundene elektrische Kontakte (7, 19) hindurchgeführt sind, wobei die Steckerwand (10, 18) eine Behälterwand des Behälters (2, 6, 15, 24) bildet.

6. Vorrichtung (1) nach einem der vorhergehenden Ansprüche,
**dadurch gekennzeichnet, dass**
die Vergussmasse (11, 25) durch ein Harz, insbesondere Epoxidharz gebildet ist.

7. Vorrichtung (1) nach einem der vorhergehenden Ansprüche,
**dadurch gekennzeichnet, dass**
die Moldmasse (12, 26) durch eine insbesondere partikeigefüllte Spritzgussmasse gebildet ist.

8. Vorrichtung (1) nach Anspruch 7,
**dadurch gekennzeichnet, dass**
die Moldmasse (12, 26) durch einen Duroplast, insbesondere Phenolharz, Melaminharz, Methanalharz, oder ein Reaktionsharz, insbesondere Polycarbonat oder partikelgefülltes Epoxidharz ist.

9. Vorrichtung (1) nach einem der vorhergehenden Ansprüche, **dadurch gekennzeichnet, dass**
die Vergussmasse (11, 25) von der Moldmasse (12, 26) verschieden ist.

10. Verfahren zum Erzeugen einer elektronischen Vorrichtung (1), insbesondere einer Vorrichtung gemäß einem der vorhergehenden Ansprüche,
bei dem ein Elektrolytkondensator (3, 13, 14) mit einem Schaltungsträger (2) elektrisch und mechanisch verbunden wird und der Elektrolytkondensator (3, 13, 14) mit einem Behälter (2, 9, 10, 16, 17, 18, 24) umschlossen wird, wonach der Behälter (2, 9, 10, 16, 17, 18, 24) mit einer insbesondere niedrigviskosen Vergussmasse (11, 25) insbesondere drucklos gefüllt wird, so dass das Bauteil (3, 13, 14) von der Vergussmasse (11, 25) umschlossen ist und ein Schutzmantel für den Elektrolytkondensator (3, 13, 14, 23) beim Einbetten der Komponenten in der Moldmasse (12, 26) ausgebildet wird, wobei der Elektrolytkondensator (3, 13, 14) in einem weiteren Schritt mit einer Spritzgussmasse (12, 26) ummoldet wird, wobei die Spritzgussmasse (12, 26) an die Vergussmasse (30) und/oder den Behälter (2, 9, 10, 16, 17, 18, 24) unter Ausbildung einer Grenzschicht (30) anschließt.

## Claims

1. Electronic apparatus (1), in particular controller for a motor vehicle, wherein the apparatus (1) has electronic components (3, 4, 29, 31, 13, 14) comprising at least one circuit carrier (2, 22) and an electrolytic capacitor (3, 13, 14, 23) connected to the circuit carrier (2, 22), wherein at least some of the components are embedded in each case at least partially in a moulding compound (12, 26),
**characterized in that**
the apparatus (1) has a container (2, 6, 15, 24) with a container opening (32) and the electrolytic capacitor (3, 13, 14, 23) is accommodated in the container (2, 6, 15, 24), wherein the container (2, 6, 15, 24) is filled with an, in particular low-viscosity, potting compound (11, 25), so that the electrolytic capacitor (3, 13, 14, 23) is surrounded by the potting compound (11, 25) and a protective casing for the electrolytic capacitor (3, 13, 14, 23) is formed when the components are embedded in the moulding compound (12, 26), wherein the moulding compound (12, 26) adjoins the container (2, 6, 15, 24) and/or the potting compound (11, 25) in the region of the container opening (32) in a materially bonded and/or cohesive manner.

2. Apparatus (1) according to Claim 1,
**characterized in that**
the container (2, 6, 15, 24) is at least partially formed by a plastic part (9, 10, 16, 17, 18, 24) which surrounds the electrolytic capacitor (3, 13, 14, 23).

3. Apparatus (1) according to Claim 1 or 2,
**characterized in that**
a container wall is formed by the circuit carrier (2) and the plastic part (6, 10) is sealed at the circuit carrier (2).

4. Apparatus (1) according to Claim 3,
**characterized in that**
the apparatus (1) has a plug-in connection (6, 10, 15, 19), and the plug-in connection (6, 15, 19) is formed by a plastic part (8, 10, 15, 18) integrally formed on the container.

5. Apparatus (1) according to Claim 4,
**characterized in that**
the plug-in connection (6, 15, 19) has a plug wall (10, 18) through which electrical contacts (7, 19) connected to the circuit carrier (2) are routed, wherein the plug wall (10, 18) forms a container wall of the container (2, 6, 15, 24).

6. Apparatus (1) according to one of the preceding claims,
**characterized in that**
the potting compound (11, 25) is formed by a resin, in particular epoxy resin.

7. Apparatus (1) according to one of the preceding claims,
**characterized in that**
the moulding compound (12, 26) is formed by an, in particular particle-filled, injection-moulding compound.

8. Apparatus (1) according to Claim 7,
**characterized in that**
the moulding compound (12, 26) is by a thermosetting plastic, in particular phenol resin, melamine resin, methanal resin, or a reaction resin, in particular polycarbonate or particle-filled epoxy resin.

9. Apparatus (1) according to one of the preceding claims,
**characterized in that**
the potting compound (11, 25) is different from the moulding compound (12, 26).

10. Method for producing an electronic apparatus (1), in particular an apparatus according to one of the preceding claims,
in which method an electrolytic capacitor (3, 13, 14) is electrically and mechanically connected to a circuit carrier (2) and the electrolytic capacitor (3, 13, 14) is surrounded by a container (2, 9, 10, 16, 17, 18, 24), after which the container (2, 9, 10, 16, 17, 18, 24) is filled, in particular without being pressurized, with an, in particular low-viscosity, potting compound (11, 25), so that the component (3, 13, 14) is surrounded by the potting compound (11, 25) and a protective casing for the electrolytic capacitor (3, 13, 14, 23) is formed when the components are embedded in the moulding compound (12, 26), wherein the electrolytic capacitor (3, 13, 14) is encapsulated by moulding with an injection-moulding compound (12, 26) in a further step, wherein the injection-moulding compound (12, 26) adjoins the potting compound (30) and/or the container (2, 9, 10, 16, 17, 18, 24) so as to form a boundary layer (30).

## Revendications

1. Dispositif électronique (1), en particulier appareil de commande pour un véhicule automobile, dans lequel le dispositif (1) présente des composants électroniques (3, 4, 29, 31, 13, 14) comprenant au moins un support de circuit (2, 22) et un condensateur électrolytique (3, 13, 14, 23) relié au support de circuit (2, 22), au moins une partie des composants étant incorporée respectivement au moins en partie dans une matière à mouler (12, 26),
**caractérisé en ce que** le dispositif (1) présente un récipient (2, 6, 15, 24) doté d'une ouverture de récipient (32), et le condensateur électrolytique (3, 13, 14, 23) est reçu dans le récipient (2, 6, 15, 24), le récipient (2, 6, 15, 24) étant rempli d'une masse de scellement (11, 25), en particulier de basse viscosité, de sorte que le condensateur électrolytique (3, 13, 14, 23) est entouré par la masse de scellement (11, 25) et une enveloppe de protection pour le condensateur électrolytique (3, 13, 14, 23) est réalisée lors de l'incorporation des composants dans la matière à mouler (12, 26), la matière à mouler (12, 26) étant adjacente au récipient (2, 6, 15, 24) et/ou à la masse de scellement (11, 25) au niveau de l'ouverture de récipient (32) par liaison de matériau et/ou par liaison de matière.

2. Dispositif (1) selon la revendication 1, **caractérisé en ce que** le récipient (2, 6, 15, 24) est formé au moins en partie par une pièce en matière plastique (9, 10, 16, 17, 18, 24) qui entoure le condensateur électrolytique (3, 13, 14, 23).

3. Dispositif (1) selon la revendication 1 ou 2, **caractérisé en ce qu'**une paroi de récipient est formée par le support de circuit (2) et la pièce en matière plastique (6, 10) est rendue étanche au niveau du support de circuit (2).

4. Dispositif (1) selon la revendication 3, **caractérisé en ce que** le dispositif (1) présente un connecteur enfichable (6, 10, 15, 19), et le connecteur enfichable (6, 15, 19) est formé par une pièce en matière plastique (8, 10, 15, 18) rapportée au récipient.

5. Dispositif (1) selon la revendication 4, **caractérisé en ce que** le connecteur enfichable (6, 15, 19) présente une paroi de connecteur (10, 18) par laquelle passent des contacts électriques (7, 19) reliés au support de circuit (2), la paroi de connecteur (10, 18) formant une paroi de récipient du récipient (2, 6, 15, 24).

6. Dispositif (1) selon l'une quelconque des revendications précédentes, **caractérisé en ce que** la masse de scellement (11, 25) est formée par une résine, en particulier une résine époxy.

7. Dispositif (1) selon l'une quelconque des revendications précédentes, **caractérisé en ce que** la matière à mouler (12, 26) est formée par une matière à mouler par injection, en particulier chargée en particules.

8. Dispositif (1) selon la revendication 7, **caractérisé en ce que** la matière à mouler (12, 26) est par un duroplaste, en particulier une résine phénolique, une résine de mélamine, une résine formaldéhyde ou une résine de réaction, en particulier du polycarbonate ou une résine époxy chargée en particules.

9. Dispositif (1) selon l'une quelconque des revendications précédentes, **caractérisé en ce que** la masse de scellement (11, 25) est différente de la matière à mouler (12, 26).

10. Procédé permettant de produire un dispositif électronique (1), en particulier un dispositif selon l'une quelconque des revendications précédentes, dans lequel un condensateur électrolytique (3, 13, 14) est relié de manière électrique et mécanique à un support de circuit (2), et le condensateur électrolytique (3, 13, 14) est entouré par un récipient (2, 9, 10, 16, 17, 18, 24), après quoi le récipient (2, 9, 10, 16, 17, 18, 24) est rempli, en particulier sans pression, d'une masse de scellement (11, 25), en particulier de basse viscosité, de sorte que le composant (3, 13, 14) est entouré par la masse de scellement (11, 25) et une enveloppe de protection pour le condensateur électrolytique (3, 13, 14, 23) est réalisée lors de l'incorporation des composants dans la matière à mouler (12, 26), le condensateur électrolytique (3, 13, 14), dans une autre étape, étant surmoulé avec une matière à mouler par injection (12, 26), la matière à mouler par injection (12, 26) étant adjacente à la masse de scellement (30) et/ou au récipient (2, 9, 10, 16, 17, 18, 24) en réalisant une couche limite (30).
